# EUROPÄISCHE PATENTSCHRIFT

(11) **EP 0 960 410 B1**
(45) Veröffentlichungstag und Bekanntmachung des Hinweises auf die Patenterteilung: **24.10.2001**
(21) Anmeldenummer: 98912206.4
(22) Anmeldetag: 12.02.1998
(51) Int. Cl.: G08C 17/02, H04B 1/04

(54) **ANORDNUNG UND VERFAHREN ZUR ERZEUGUNG KODIERTER HOCHFREQUENZSIGNALE**
DEVICE AND METHOD FOR PRODUCING CODED HIGH-FREQUENCY SIGNALS
DISPOSITIF ET PROCEDE POUR PRODUIRE DES SIGNAUX HAUTE FREQUENCE CODES

(30) Priorität: 12.02.1997 DE 19705341; 15.04.1997 DE 19715727; 15.04.1997 DE 19715728
(43) Veröffentlichungstag der Anmeldung: 01.12.1999
(73) Patentinhaber: SIEMENS AKTIENGESELLSCHAFT, 80333 München (DE)
(72) Erfinder: GERLACH, Horst, D-93073 Neutraubling (DE); KAMMERL, Franz, D-93193 Holzheim (DE); SCHOLL, Gerd, D-80636 München (DE); OSTERTAG, Thomas, D-85464 Finsing (DE); SCHMIDT, Frank, D-85604 Pöring (DE); BULST, Wolf-Eckhart, D-81739 München (DE)
(86) Internationale Anmeldenummer: DE9800403
(87) Internationale Veröffentlichungsnummer: WO9836395

(56) Entgegenhaltungen:
- EP-A- 0 319 781
- WO-A-96/15590
- DE-A- 4 105 339
- DE-A- 4 309 006
- FR-A- 2 646 021
- US-A- 3 596 262
- US-A- 3 824 857
- US-A- 4 177 438
- US-A- 5 301 362

## Beschreibung

Es ist bekannt, Hochfrequenzenergie und -signale mit Hilfe von niedrigfrequenter elektrischer Energie, z.B. (Batterie-) Gleichstrom-, Netzfrequenzstrom- und dgl. Energie aus ähnlichen Energiequellen zu erzeugen. Weit verbreitet sind netzgespeiste Hochfrequenzsender und batteriegetriebene HF-Sendegeräte wie Funkgeräte, Mobiltelefone (Handy) oder schnurlose Telefone bekannt. Mit solchen Geräten können nicht-kodierte, vorzugsweise jedoch kodierte/modulierte Hochfrequenzsignale für vielfältige Funk-Informationsübertragungen ausgesendet werden. Für die Fälle des Batteriebetriebs kann auch Solarenergie als primäre Energiequelle dienen, mit deren Hilfe eine wiederaufladbare Batterie bzw. ein Akkumulator bei Vorhandensein ausreichender Beleuchtung wieder aufgeladen bzw. in seinem Ladezustand gehalten werden kann.

Das Dokument US-A-3596262 offenbart eine Anordnung zur Erzeugung kodierter Hochfrequenzsignale mit einem Wandler (ein magnetischer Stromgenerator), der eine aus der Umgebung der Anordnung verfügbare nicht-elektrische Primärenergie (mechanische Energie) in niederfrequente elektrische Energie umsetzt, einer Gleichrichtungseinheit zur Erzeugung eines gepulsten Gleichstroms, einer Sendeeinheit mit einem Schwingkreis und einer Kodierungseinrichtung, die die Oszillationsfrequenz des Schwingkreises beeinflußt.

Es ist auch bekannt, physikalische und dergleichen Daten, Meßgrößen usw. fernabzufragen. Ein Beispiel für eine derartige Fernabfragung ist z.B. ein Fernthermometer, mit dem die Temperatur, z.B. eines Heißkessels, gemessen und an vom Kessel entferntem Ort angezeigt wird. Ein rein elektrisch arbeitendes Fernthermometer hat dafür eine zweiadrige elektrische Leitung zwischen dem temperaturempfindlichen Fühler und dem eigentlichen Anzeigegerät.

Bekannt sind auch fernabfragbare Einrichtungen, bei denen die Verbindung zwischen Fühler und Anzeigegerät eine Übertragung auf dem Funkwege ist. Die Datenübertragung erfolgt zwar drahtlos, jedoch ist am Ort des Fühlers, nämlich für den Sender, eine Quelle für elektrische Energie erforderlich. Soll vollständig drahtlose Verbindung vorliegen, bedient man sich daher einer elektrischen Batterie-Energiespeisung am Ort der Datenabfrage (sofern dort nicht anderweitig eine elektrische Quelle zur Verfügung steht). Bekannt sind weiterhin fernabfragbare Einrichtungen ohne elektrische Versorgung am Fühler, bei denen die für die Datenübertragung nötige Energie drahtlos mit einem entsprechend energiereichen und breitbandigen Abfrageimpuls in eine Oberflächenwelleneinrichtung eingekoppelt und von dort nach geeigneter Signalverarbeitung passiv zurückgesendet wird. Nachteilig daran ist jedoch, daß der energiereiche Abfrageimpuls regelmäßig und um so öfter ausgesendet werden muß je genauer die Meßgröße ermittelt bzw. beobachtet werden soll.

Aufgabe der vorliegenden Erfindung ist es, für einen spezielleren Betriebsfall eine vorteilhaft anzuwendende Erzeugung der für einen solchen Sender notwendigen elektrischen Energie anzugeben. Dieser speziellere Betrieb besteht darin, nur in lediglich relativ kurzen interessierenden Zeitintervallen eine Funk-Informationsübertragung durchzuführen, wobei die Länge eines jeweiligen solchen Zeitintervalles klein (z.B. nur 1 Promille und kleiner) ist gegenüber den Pausen zwischen solchen aufeinanderfolgenden Zeitintervallen.

Diese Aufgabe wird mit einer Anordnung nach Anspruch 1 gelost. Vorteilhafte Ausgestaltungen sowie ein Verfahren zur Erzeugung kodierter Hochfrequenzsignale gehen aus weiteren Ansprüchen hervor.

Der Erfindung liegt der Gedanke zugrunde, vorzugsweise aus dem Blickwinkel der Einsparung technischen Aufwandes und auch minimierter Wartung ein Prinzip zu finden, das eine für den jeweiligen Fall völlig ausreichende Funk-Informationsübertragung unter Aufwand anderer als elektrischer Primärenergie ermöglicht.

Den Beschreibungen einzelner Beispiele vorausgeschickt sei kurz umrissen das der Erfindung zugrundeliegende Prinzip genannt, zu dessen eingehenderem Verständnis die dann noch nachfolgenden Beschreibungsteile dienen.

Erwähnt ist bereits der Fall der photovoltaischen Umwandlung, die jedoch bekanntermaßen und ersichtlich nur eingeschränkt nutzbar zu machen ist. Sie ist abhängig von ausreichendem Lichteinfall und meist nur in Verbindung mit Energiespeicherelementen - Akkumulatoren - vernünftig nutzbar.

Die Erfindung ist darauf ausgerichtet, bisweilen sogar in sehr großer Menge verfügbare Energie, hier als aus der Umgebung verfügbare Primärenergie bezeichnet, zu nutzen, um erfindungsgemäß elektrische Energie zum Erzeugen eines hochfrequenten Signals (Funksignal) bereitzustellen.

Solche üblicherweise nicht genutzten Primärenergien sind mechanische Verformungsenergie, insbesondere Druck oder andere Kräfte, Reibungskräfte (Niedrigtemperatur-) Wärmeenergie, Beschleunigungskräfte, Strahlung, schwingende Massen und dergleichen. Soweit hier Kräfte angeführt sind, wird für die Erfindung deren zeitlicher oder örtlicher Gradient genutzt, der zu einer Energie äquivalent ist.

Als Beispiele bislang ungenutzter Primärenergien seien die für die Betätigung eines elektrischen Schalters prinzipiell erforderliche Druck-/Verformungsenergie, mit räumlichem oder zeitlichem Temperaturgradienten verfügbare Wärme, z.B. eines Heizkörpers, und Beschleunigungsenergie einer schwingenden seismischen Masse, z.B. in einem Fahrzeug. Geeignet als Primärenergien sind auch Rütteln, Vibrieren, Luftbewegungen, Diese beispielhafte Aufzählung ist betreffend die Erfindung nicht erschöpfend und in keiner Weise als Beschränkung der Anwendung des Erfindungsprinzips zu sehen.

Das integrale Prinzip der Erfindung besteht im wesentlichen darin, aus solcher Prozeßenergie einen Energieanteil abzuzweigen und diesen zunächst in wie hier definiert niederfrequente elektrische Energie umzuwandeln. In allgemeinster Form wird erfindungsgemäß darunter bereits die Trennung von Ladungen verstanden, wie sie z.B. als elektrostatische Aufladung durch Reibung entsteht. Als niederfrequent wird erfindungsgemäß auch das Erzeugen einer Spannung mit langsam ansteigender Amplitude verstanden. Auch die in pyro- oder piezoelektrischen sowie in photovoltaischen Bauelementen erzeugte Spannung läßt sich erfindungsgemäß nutzen.

Ein nächster Schritt ist, diese sogenannte niederfrequente elektrische Energie in hochfrequente elektrische Energie zu transformieren. Dazu kann erfindungsgemäß ein Element mit nicht-linearer Kennlinie (nicht-lineares Element) dienen. Darunter wird im Sinne der Erfindung ein Element verstanden, dessen Verhalten sich in Abhängigkeit von der angelegten Spannung ab einem bestimmten Grenzwert oder in einem Grenzwertbereich sprunghaft ändert. Als Ergebnis erzeugt ein solches Element einen Stromimpuls mit steiler Flanke, was im Frequenzbereich einem Hochfrequenzsignal entspricht.

Je nach der Bandbreite dieses Hochfrequenzsignals ist es gegebenenfalls nötig, daraus ein schmalbandigeres Frequenzspektrum herauszufiltern. Möglich ist es jedoch auch, ein nicht-lineares Element zu verwenden, das für sich bereits ein ausreichend schmalbandiges Hochfrequenzsignal erzeugt.
Damit gelingt es, den vollen Energiegehalt des Hochfrequenzsignals zu nutzen.

Ein weiterer Schritt der Erfindung ist, diese hochfrequente elektrische Energie mit einer Information zu kodieren und als kodiertes (schmalbandiges) Hochfrequenzsignal auszusenden. Diese Kodierung kann zur Identifizierung geeignet sein und/oder noch andere Informationen enthalten, z.B. über die Art und Größe von auf die Kodierungseinrichtung einwirkenden Parametern. Dies können bestimmte physikalische Größen wie etwa eine Temperatur, eine Kraft oder ein Impedanzsprung sein, ebenso aber auch chemische oder biologische Parameter, z.B. Konzentration und/oder Art von Gasen, Dämpfen, Flüssigkeiten, Stoffen oder biologischem Material wie z.B. Viren oder Genen.

Ausgesendet wird ein kodiertes Hochfrequenzsignal, dessen Energieinhalt bei gegebenenfalls vorgenommenener Schmalbandselektion zwangsläufig relativ gering ist, jedoch trotzdem im Anwendungsrahmen der Erfindung ausreichend groß ist. Überraschend ist, daß trotz eines geringen Umsetzungsgrades der genutzten Primärenergie hin zur Energie des erzeugten kodierten Hochfrequenzsignals keinerlei Problem hinsichtlich der nutzbringenden Anwendung der Erfindung besteht.

Hierzu ist ergänzend darauf hinzuweisen, daß die (in angemessen begrenzter Entfernung positionierte) Funk-Empfangsstation in an sich bekannter Weise so ausgebildet und ausgestaltet ist, daß sie die Information des empfangenen (kodierten) schmalbandigen Hochfrequenzsignals erfassen kann. Auf der Funkempfangsseite ist dies deshalb kein Problem, weil dort die energetische Versorgung des Empfängers in herkömmlicher Weise, z.B. durch ein Stromnetz, Batterien oder dgl. gewährleistet werden kann.

Dem vertieften Verständnis der Erfindung dienen die weiteren Erläuterungen/Beschreibungen von Ausführungs-/ Anwendungsbeispielen und der dazugehörigen Figuren.
Figur 1 zeigt ein Blockschaltbild des Energieflusses.
Figur 2 zeigt das Prinzip eines Aufbaues.
Figur 3 zeigt einen integrierten Aufbau in schematischer Draufsicht
Figuren 4a und 4b zeigen zwei Ausführungen eines integrierten Aufbaus in der Seitenansicht (schematisches Schnittbild).

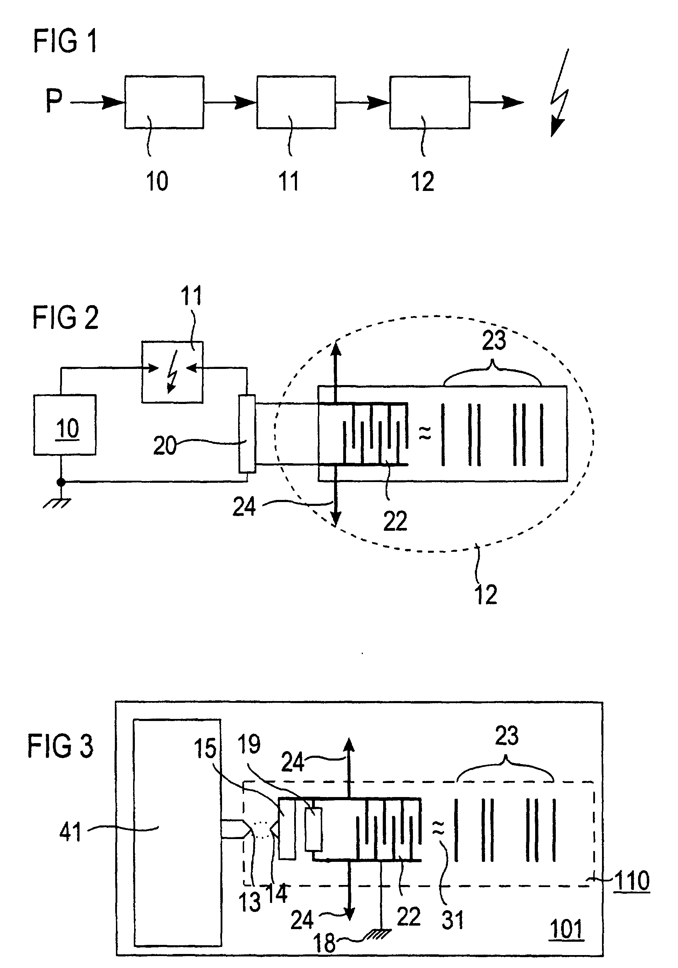

Figuren 1 und 2: Gemäß dem Blockschaltbild nach Figur 1 ist ein Wandler 10 vorgesehen, der (die) jeweils zur Verfügung stehende Prozeß-energie in elektrische Energie umwandelt. Beispiele für einen solchen Wandler 10 sind ein piezoelektrisches Element zur Umwandlung von Druck/Verformungsenergie, ein pyroelektrischer Körper, ein Thermoelement-Paar, ein Element mit Seebeck-/ Peltier-Effekt oder dgl. zur Transformation von Wärmeenergie mit Temperaturgradient, ein elektrodynamisches oder piezoelektrisches System zur Umsetzung von Schwingungs- / Beschleunigungsänderungs-Energie in diese (hier für alle diese Beispiele) als niederfrequent definierte (elektrische) Energie. Auch Solarzellen sind geeignet. Möglich ist es auch, als Wandler (10) ein Reibungselement zu verwenden, bei dem die Reibung zwischen zwei sich unterschiedlich aufladenden Materialien eine elektrostatische Spannung als niederfrequente Energie erzeugt.

Die Höhe der erforderlichen Spannung richtet sich nach dem nichlinearen Element und reicht von einigen hundert bis tausend Volt für eine Funkenstrecke über einige zehn bis zwanzig Volt für Halbleiter-Bauelemente bis zu wenigen Volt, wie sie für Relais ausreichend sind.

Mit 11 ist ein nicht-lineares Element bezeichnet. Es dient der Transformation dieser sogenannten niederfrequenten Energie in hochfrequente Energie unter Einbezug eines inneren Schaltvorganges zur Auslösung eines in Zeitabständen erfolgenden Überganges aufgespeicherter Niederfrequenzenergie in Energie, die dann hochfrequente Eigenschaft annimmt/angenommen hat. Beispiele für ein solches nicht-lineares Element sind insbesondere eine Funkenstrecke, oder eine Gasentladungsröhre. Geeignet ist auch eine Diode mit beispielsweise Varaktor- oder Avalanche-Effekt oder ein Thyristor oder einähnlich wirkendes Halbleiterbauelement. Prinzipiell sind auch Schalter oder Relais geeignet, die zur Schaltung der teilweise geringen Ströme der niederfreqenten elektrischen Energie geeignet sind und ein entsprechendes nicht-lineares Verhalten zeigen. Beispielhaft seien hier Silizium Mikrorelais und Relais mit piezoelektrischer Zunge angeführt.

Als Kodierungseinrichtung 12 mit gegebenenfalls zusätzlicher Filtereigenschaft kommt eine Vielzahl von Anordnungen in Betracht. Insbesondere eignen sich hierfür mit Oberflächenwellen (OFW/SAW), Scherwellen oder oberflächennahen Volumenwellen arbeitende Anordnungen. Dies können Resonator-Anordnungen oder ggf. dispersive oder angezapfte Verzögerungsleitungen sein. Auch elektroakustische Wandler allgemein sind geeignet, ebenso dielektrische Filter, mechanische Filter, Koaxial-Keramikfilter, Volumenschwinger z.B. Schwingquarze oder LC-Schwingkreis-Filter oder dgl.. Als piezoelektrische Materialien für solche elektroakustischen Wandler sind insbesondere geeignet Lithiumniobat, Lithiumtantalat, Quarz, Li₂B₄O₇ oder Langasit (Lanthan-Gallium-Silizium-Oxid).

Als Kodierungseinrichtung können vorteilhaft auch elektroakustische Wandler mit Pulskompression (spread spectrum comunication oder Breitbandkodierverfahren) eingesetzt werden. Diese erlauben eine Übertragung des kodierten HF Signals, die besonders störsicher ist und damit geschützt gegen natürliche (HF-) Störungen oder gegen absichtliche unautorisierte Beeinflussung des kodierten Signals. Dies sind z.B. die genannten dispersiven oder angezapften Verzögerungsleitungen.

Das Hochfrequenzsignal kann in einem beliebigen für die Funkübertragung bekannten oder geeigneten und mit den genannten Filtern oder Kodierungseinrichtungen erzeugbaren Frequenzbereich liegen, z.B. von wenigen Kiloherz bis zu mehreren Gigaherz.

Nachfolgend werden spezielle, praktisch anwendbare Ausführungsformen zur Erfindung beschrieben. Eine erste Ausführungsform gemäß der Figur 2 ist z.B. als ein Schalter zum Einschalten eines Gerätes, einer Beleuchtung und dgl. zu verwenden. Ein sehr interessantes Anwendungsbeispiel ist der Lichtschalter in Räumen, mit dem von Hand die Beleuchtung ein- bzw. ausgeschaltet wird. Dieser Schalter bedarf überhaupt keiner Zuleitung und kann ohne jegliche elektrische Kabel-Installationsarbeit an der Wand oder dgl. angebracht werden. Bei Drücken des Schalters erfolgt mit Hilfe der Erfindung das Aussenden eines Hochfrequenzsignals, und zwar ohne daß diesem Schalter von außen elektrischer Strom zugeführt wird. Ein irgendwo im Raum, z.B. in der Nähe der Lampe, angebrachter Empfänger spricht auf das Hochfrequenzsignals an und schaltet diese Beleuchtung drahtlos ferngesteuert ein bzw. aus. Die Figur 2 zeigt schematisch den Aufbau des die wesentlichen Gedanken der Erfindung umfassenden Teils eines erfindungsgemäß Prozeßenergie nutzenden drahtlosen Schalters mit Funksignalen. Der Wandler 10 wird (wie ein konventioneller Druckschalter) mit Fingerdruck P beaufschlagt und dieser Druck P erzeugt in dem hier piezoelektrischen Element des Wandlers 10 eine Piezospannung. Als piezoelektrische Materialien für solche Wandler sind neben den für die elektroakustischen Wandler genannten insbesondere noch PVDF (Polyvinylidendifluorid) und ferroelektrische flüssigkristalline Elastomere (FLCE) geeignet.

Ein solcher Schalter kann auch als Aktor ausgebildet sein, mit dem ein HF-Signal erzeugt und ausgelöst wird, dem mittels der Kodierung eine Informamtion über eine Umgebungsparameter aufgeprägt werden kann.

Zur Erzeugung einer hohen Piezospannung eignet sich insbesondere eine mechanische Betätigungsvorrichtung mit Über-Totpunkt-Feder, die bei einer Belastung über den Totpunkt hinaus schlagartig mit der eingestellten (mechanischen) Vorspannung auf den Wandler einwirkt.

Der Wandler 10 umfaßt integral oder ergänzend eine elektrische Aufladekapazität 10', die die erzeugten bzw. getrennten Ladungen bis zur Auslösung des nicht-linearen Elements speichert. Die innere Kapazität von Piezo- oder Pyrowandlern kann dazu ausreichend sein.

In dem dargestellten Stromkreis ist als nicht-lineares Element 11 z.B. eine Funkenstrecke vorgesehen, in der im Augenblick, in dem die piezoelektrisch erzeugte Spannung genügend hoch angestiegen ist, ein Funkenüberschlag erfolgt.

Eine solche Funkenstrecke erfüllt die für das Funktionieren der Erfindung zu erfüllende Bedingung eines z.B. im Nanosekunden-Bereich erfolgenden elektrischen (Strom-)Durchbruchs zur Umsetzung in Hochfrequenzenergie. Alternativ können wie bereits erwähnt auch andere Elemente mit entsprechend schnellem Durchbruchsverhalten verwendet werden.

Der Strom dieses Funkenüberschlags geht durch eine Induktivität, z.B. ein breitbandiges Filter 20, um den Stromkreis zu schließen. Der in dieser Induktivität 20 auftretende Spannungsabfall speist die Interdigitalstruktur 22 (Wandlerelektroden) eines Oberflächenwellenfilters 21. In diesem wird bekanntermaßen eine mechanische/akustische Welle erzeugt. Die Kodierung kann durch spezielle Ausgestaltung der Interdigitalstruktur auf der Eingangs- und/oder Ausgangsseite des Filters erfolgen. Auch kann ein gemäß einer Kodierung angeordnetes Musters 23 von Reflektorstreifen vorgesehen werden, deren "Echos" die Kodierung bilden. Wird im Filter eine Kavität ausgebildet, kann sich eine resonante Schwingung ausbilden, deren genaue Frequenz die Kodierung bildet. Am Filterausgang wird das kodierte Signal erhalten.

Im Ausführungsbeispiel führt das Zusammenwirken der Interdigitalstruktur und der Reflektorstreifen bekanntermaßen dazu, daß an den Dipolen der dargestellten Antenne 24 das voranstehend beschriebene (hier mit dem Kode der Struktur 23 kodierte) Hochfrequenz-Funksignal auftritt und zu dem oben erwähnten Empfänger ausgesendet wird. Eine als reflektierende Verzogerungsleitung arbeitende Oberflächenwellenanordnung liefert eine Kodierung im Zeitbereich und eine als Resonator arbeitende Anordnung (in der Figur nicht dargestellt) liefert eine Kodierung im Frequenzbereich. Auch dabei läßt sich die Kodierung in Abhängigkeit eines Umgebungsparameters vornehmen.

Zur Beschreibung einer anderen Ausführungsform der Erfindung genügt wieder die Figur 2. Bei einer Ausführungsform zur Nutzung von thermischer Prozeßenergie ist der Wandler 10 z.B. ein mit Elektroden versehener pyroelektrischer Körper (Pyroelement). Für diese Ausführungsform stellt der Pfeil P die Zufuhr von Wärmeenergie dar. Zur erfindungsgemäßen Nutzung ist es erforderlich, daß diese thermische Primärenergie einen z.B. zeitlichen Temperaturgradienten hat. Dies liegt z.B. bei (wie zur Raumheizung benutzten) Heizkörpern mit thermostatischer Regelung vor, die Temperaturschwankungen des Heizkörpers im Bereich von einigen Grad Kelvin bewirkt, die für die erfindungsgemäßen Zwecke (wenn auch überraschenderweise) völlig ausreichend sind. Bei dieser beschriebenen Ausführungsform erfährt der Wandler 10 abwechselnd Erwärmung und Abkühlung, was zu Ausbildung von am Pyroelement anliegender Spannung wechselnder Größe und Polarität führt. Das nicht-lineare Element, auch hier kann dies wieder eine Funkenstrecke sein, bewirkt, daß bei Erreichen einer bestimmten (positiven oder negativen) Spannungsänderung ein Funkenüberschlag erfolgt, der die Vorgänge auslöst, die bereits zur piezoelektrischen Ausführungsform vorangehend beschrieben sind.

Ein diesbezüglich besonders interessanter Anwendungsfall ist die bisher mit anderer Energieversorgung arbeitende an sich bekannte Fern-Erfassung von Wärmeverbrauchs-Daten von Raumbeheizungen. Eine wie beschriebene Ausführungsform gemäß dem Prinzip der Erfindung kann dafür, nämlich ohne elektrische Energiezufuhr, sogar in zweifacher Weise vorteilhaft verwendet werden. Der zweite Vorteil besteht darin, daß in an sich im Prinzip bekannter Weise das Oberflächenwellenelement 21 auch zur direkten Temperaturmessung verwendet werden kann. Die Mittenfrequenz bzw. Laufzeit des schmalbandigen Hochfrequenz-Ausgangssignals des Oberflächenwellenwandlers ist bzw. kann temperatursensitiv (ausgeführt) sein. Steht dieses Oberflächenwellenelement mit dem z.B. Heizkörper in thermischer Verbindung, kann mit der erfindungsgemäßen Ausführungsform in einer Einheit sowohl die Temperatur gemessen werden als auch mit zugeführter Wärme die notwendige elektrische Energie für den erfindungsgemäß bewirkten Hochfrequenz-Sendevorgang erzeugt werden. Jedes Signal zeigt damit einen Temperaturwechsel bzw. einen Schaltvorgang an und liefert gleichzeitig die entsprechende auf den Wandler (Pyroelement) einwirkende Temperatur. Möglich ist es auch, die Wärmeenergie nur zur Transformation in den HF Impuls zu verwenden, die Kodierung aber in Abhängigkeit von einer beliebigen anderen variablen Größe in der Umgebung der Anordnung vorzunehmen.

Eine Ausführungsform mit Nutzung von Prozeßenergie aus beschleunigungsveränderten mechanischen Bewegungen einer seismischen Masse läßt sich ebenfalls mit der Figur 2 beschreiben. Der Wandler umfaßt dann diese seismische Masse und der Pfeil P symbolisiert die mechanische Energiezufuhr, die zu den Schwingungen der im Wandler 10 enthaltenen seismischen Masse führt. Diese mechanische Energiezufuhr kann kontinuierliche Wechselenergie oder auch nur jeweils einmalige Impulsenergie sein. Mittels eines Exzenters läßt sich auch die Energie rotierender Gegenstände in ein HF Signal transformieren, das dann wiederum mit Aussagen über beliebige Umgebungsparameter kodiert werden kann. Auch Vibrationen lassen sich mit seismischen Massen oder mit piezoelektrischen Wandlern bestimmen und/oder zur Transformation nutzen.

Anwendungen der Erfindung bieten sich in vielfältiger Weise z.B. im Bereich des Betriebs von Maschinen, Fahrzeugen verschiedenster Art, z.B. von Eisenbahnwagen, Straßenfahrzeugen, rollenden Paletten und dgl., zur Überwachung oder Beobachtung von flüssigen, gelösten, gas- oder dampfförmigen Medien verschiedenster Art oder auch von zu überwachenden Lebewesen an. Ein solcher Gegenstand oder ein Lebewesen, mit einer erfindungsgemäßen Anordnung ausgerüstet, kann (ohne daß eine elektrische Batterie benötigt wird) erfindungsgemäß in zeitlichen Abständen fortlaufend (solange es sich bewegt oder bewegt wird) kodierte Hochfrequenzsignale aussenden. Dies kann dazu benutzt werden, aufgrund individuell/ unterschiedlich kodierter HF-Signale an den jeweiligen Gegenständen oder Lebewesen, diese aus der Ferne voneinander zu unterscheiden und gleichzeitig deren Beschleunigungs- oder Bewegungsdaten, Temperatur oder sonstigen Zustand zu erfassen. Bei Lebewesen könnte so z.B. die Bewegungsaktivität von Weidetieren, Kindern oder anderen pflege- oder überwachungsbedürftigen Personen automatisch erfaßt werden. Möglich ist es z.B., auch hier einen bestimmten Grenzwert für die Bewegungsaktivität einzustellen, wobei das kodierte Signal bei Über- oder Unterschreiten derselben ausgelöst bzw. ausgesendet wird.

Es können erfindungsgemäße Anordnungen zum automatischen Erfassen bestimmter (z.B. thermischer oder mechanischer) Grenzbelastungen eingesetzt werden, die erst beim Erreichen dieser Grenzbelastung ein HF Signal erzeugen und dieses drahtlos an eine Empfangsstation bzw. an eine Überwachungseinrichtung weiterleiten. So ist eine einfache erst im Bedarfsfall aktive Überwachung von physikalischen Größen möglich. Die Höhe der Grenzbelastung kann durch den Ansprechpunkt des nicht-linearen Elements oder des Wandlers gegeben oder variierbar einstellbar sein. Eine mechanische Grenzbelastung kann auch durch eine zusätzliche vorgespannte Feder eingestellt werden, die das Ansprechen des (piezoelektrischen) Wandlers erst beim Erreichen der Vorspannkraft möglich macht. Damit läßt sich auch eine automatische Gewichtskontrolle realisieren, die beim Unter- oder Überschreiten eines bestimmten Gewichts diese Information automatisch über ein kodiertes Signal an einen Empfänger bzw. eine Überwachungseinrichtung sendet. Auch eine Gewichtsveränderung läßt sich so erfassen. Damit kann die erfindungsgemäß Anordnung auch zur Überwachung gegen Diebstahl eingesetzt werden.

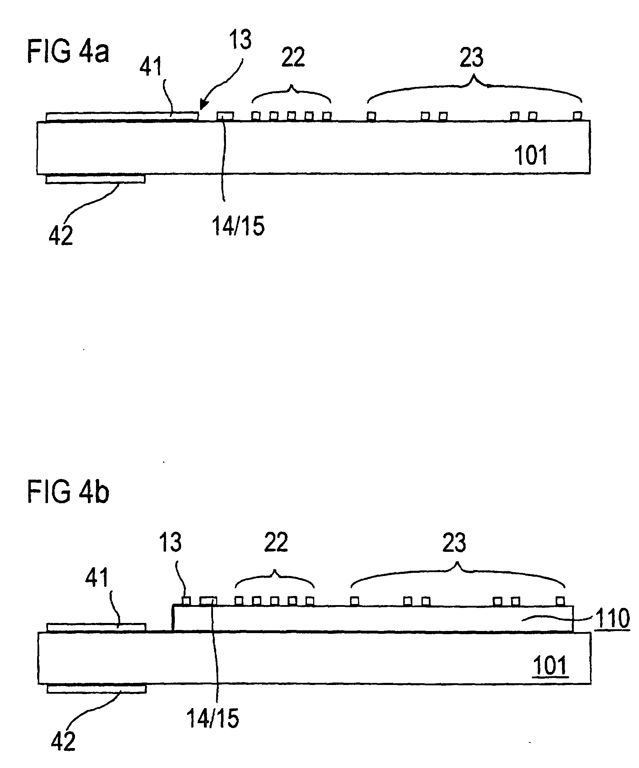

Figuren 3 und 4 zeigen die Ausgestaltung einer als Wärmemesser einsetzbaren integriert aufgebauten erfindungsgemäßen Anordnung. Mit 101 ist ein (z.B. 1 cm² großer) plättchenförmiger Substratkörper mit (unter anderem) pyroelektrischer Eigenschaft bezeichnet. Zum Beispiel kann dies eine Keramik aus Bariumtitanat, Bleizirkonat-Titanat oder dgl. oder auch ein (ein-)kristallines Material aus Lithiumniobat, Lithiumtantalat oder dgl. sein. Auf den zwei Plättchenoberfläche sind zwei Flächenelektroden 41 und 42 vorgesehenen, an denen eine erzeugte pyroelektrische Spannung abgreifbar ist.

Auf dem Substratplättchen 101 ist bei der zweiten Variante nach Figur 4b ein piezoelektrisches Plättchen 110, z.B. aufgeklebt, angeordnet, das einer noch zu beschreibenden Oberflächenwellenanordnung und weiteren Funktionen dient. Eine optimiertere Ausführungsform ist die Ausführungsvariante der Figur 4a, bei der dieses piezoelektrische Plättchen 110 ein integraler Bereich des Substratplättchens 101 ist, vorausgesetzt, das pyroelektrische Material des Substratplättchens 101 hat außerdem zumindest in diesem Bereich auch piezoelektrische Eigenschaft (und eignet sich auch für eine Oberflächenwellenanordnung) wie dies bei Lithiumniobat, Lithiumtantalat und dgl. (einkristallinem) Material der Fall ist.

Es sei der Vollständigkeit halber darauf hingewiesen, daß für das Prinzip der Variante nach Figur 4b das pieozoelektrische Plättchen 110 lediglich elektrisch verbunden örtlich auch getrennt vom plättchenförmigen Körper 101 positioniert sein kann, z.B. wenn das Plättchen 110 vom Körper 101 thermisch isoliert sein soll. Auch bei einer solchen Variante ist das erfindungsgemäße Prinzip von der Umwandlung der Wärmeenergie in ein Hochfrequenzsignal voll funktionsfähig. Auf den Vorteil einer Wärmekopplung zwischen pyroelektrischem Körper 101 und dem piezoelektrischen Plättchen 110 der Oberflächenwellenanordnung hinsichtlich damit verbundener Möglichkeit der Messung des jeweiligen Temperaturwertes wird noch weiter unten eingegangen. Auch im Hinblick darauf ist die Verwendung eines integralen einstückigen Plättchens als Substrat 101 und Plättchen 110 für die Oberflächenwellenanordnung, und zwar aus einkristallinem Lithiumtantalat, Lithiumniobat und dgl., für die Erfindung von besonderem Interesse.

Wie in den Figuren 4a und 4b dargestellt, ist die (untere) Rückseite des Substratkörpers 101 vorzugsweise ganzflächig, z.B. mit Aluminium (42) metallisiert. Die gegenüberliegende obere Seite des Substratkörpers 101 ist bei der Variante nach Figur 4b vorzugsweise ebenfalls ganzflächig metallisiert (41). Bei der Variante nach Figur 4a ist der Anteil des Substratkorpers 101, der hier funktionell als piezoelektrisches Plättchen 110 wirkt/dient, in der oberen Metallisierung ausgespart, nämlich um in dieser ausgesparten Fläche die noch nachfolgend beschriebenen weiteren Strukturen zu plazieren. Bei der Variante nach Figur 4b sind diese Strukturen auf dem separaten Plättchen 110 angeordnet. Entkopplung mechanisch-thermischer Spannungen zwischen den Teilen 101 und 110 erzielt man, wenn man das Plättchen 110 statt dessen mit ohnehin erforderlichen Bonddrähten auf dem Körper 101 befestigt.

Mit 13 und 14 sind je eine Elektrode für eine Funkenstrecke bezeichnet, die, wie aus den Figuren ersichtlich, mit zueinander zugewandten Spitzen einander gegenüberstehen. Die Funkenelektrode 13 ist mit der Metallisierung 41 elektrisch verbunden. Die Funkenelektrode 14 ist als Gegenelektrode elektrisch mit einer Metallisierung 15 verbunden, die ihrerseits über Leitungen und eine noch näher zu beschreibende Drosselspule 19 mit einem Masseanschluß 18 verbunden ist, der wiederum mit der rückseitigen Metallisierung 42 des Substrats 101 verbunden ist. Entsteht zwischen den beiden Elektroden 41 und 42 eine pyroelektrische Spannung, so steht diese zwischen den Funkenelektroden 13 und 14 an und aufgrund der nichtlinearen Zündkennlinie dieser Funkenstrecke erfolgt der Überschlag erst ab einem durch die Geometrie der Funkenelektroden 13 und 14 vorgegebenen akkumulierten Pyro-Spannungswert. Die erwähnte Drossel 19dient als Gleichstromleitung/Tiefpaßfilter. Diese Drossel ist vorzugsweise eine als Leiterstreifen auf die Oberfläche des Plättchens 110 aufgebrachte Mäanderstruktur oder Spiralstruktur.

Mit insbesondere der dargestellten und beschriebenen ersten Variante (Figur 4a) der Ausführung einer erfindungsgemäßen Vorrichtung kann auch gleichzeitig die Temperatur gemessen werden. Das Substrat 101 und das darin anteilsmäßig funktionell enthaltene Plättchen 110 ist mit der Wärmequelle ohnehin des pyroelektrischen Effekts wegen wärmemäßig gekoppelt. Das heißt, der Bereich 110 der Oberflächenwellenstruktur 22/23 nimmt die Temperatur des Heizkörpers an, die mit der erfindungsgemäßen Vorrichtung gemessen werden soll.

Das OFW Bauelement erzeugt ein von der Temperatur abhängiges Hochfrequenzsignal. Das heißt, daß das abgestrahlte kodierte Signal die Information der augenblicklichen Temperatur des Plättchens (und damit des Heizkörpers) enthält. Am Ort des Empfangs bzw. in einer Empfangs- und Auswerteeinheit kann der ausgesandten Welle auf diese Weise die Heizkörpertemperatur aus dem kodierten Signal ermittelt werden. Um dies bei der zweiten Variante zu erzielen, wird das dort separate Plättchen 110 mit der Wärmequelle (dem Heizkörper oder dgl.) gesondert wärmegekoppelt.

Durch eine entsprechende Bemessung der Funkenstrecke der Elektroden 13 und 14 und des Wärmekontakts der Vorrichtung mit der Wärmequelle (dem Heizkörper), d.h. durch Bemessung des Wärmezuflusses in das pyroelektrische Substrat 10, kann eine vorgebbare Zeitfolge der aufeinanderfolgenden Funkenauslösungen gewählt bzw. bestimmt werden. Damit ist der Takt der Abstrahlung von Signalen von der Antenne 24 gegeben. Da die zentrale Empfangsstelle eine Vielzahl von solchen Meßstellen, d.h. eingehenden Signalen verschiedener Meßstellen, zu erfassen hat,.wäre es an sich notwendig, das Signalaussenden der Einzelmeßstellen zeitlich zu koordinieren. Tatsächlich ist es aber so, daß von der einzelnen Meßstelle ein nur Mikrosekunden langer Sendeimpuls von der zentralen Stelle zu empfangen ist, d.h. das Taktverhältnis von Sendeimpuls zu zeitlichem Impulsabstand extrem klein ist. Eine Koinzidenz des Aussendens zweier verschiedener solcher Meßstellen ist daher extrem unwahrscheinlich und es entsteht kein unnötiger Elektrosmog.

Bei der Erfindung ist eine Kodierung insbesondere mit dem Muster der Reflektorstruktur 23 auf dem OFW Bauelement vorgesehen. Die Vielfalt der möglichen Codes ist, wie von solchen Streifenmustern her bekannt, außerordentlich groß. Mit einer erfindungsgemäßen Vorrichtung ist die Identifizierung einer einzelnen solchen Meßvorrichtung durch die zentrale Stelle problemlos.

Die erfindungsgemäße Anordnung kann somit integriert auf kleinster Substratfläche 101 untergebracht werden. Sie ist somit handlich und läßt sich problemlos an den verschiedensten auch unzugänglichen Orten anbringen. Durch die integrierte Bauweise ist die Anordnung auch kostengünstig herzustellen. Das hier für einen Wärmemesser ausgeführte Beispiel läßt sich problemlos auch auf entsprechende Piezoelemente oder andere keramische oder aus Halbleiter gefertigte Wandler 10 für die zu nutzende Primärenergie übertragen.

Zu einem System, das mit einer wie erfindungsgemäßen Anordnung arbeitet, gehört die schon mehrfach genannte Funk-Empfangsstation mit Signalauswertung. Innerhalb dieses Systems bedarf es keiner Drahtverbindung zwischen der Anordnung und der Empfangsstation und die Anordnung selbst bedarf keiner elektrischen Energiezufuhr von außen, obwohl sie keine elektrische Batterie enthält. Es sei jedoch auf einen Sonderfall hingewiesen, bei dem eine von der Erfindung Gebrauch machende Anordnung doch eine aufladbare Batterie enthält, die jedoch (ohne elektrische Energiezufuhr von außen) aus erfindungsgemäß erzeugter, wie hier definiert niederfrequenter elektrischer Energie über den Zeitablauf hinweg immer wieder aufgeladen wird. Die damit gewonnene Autarkie der Anordnung beruht gänzlich auf der Nutzung der Erfindung.

### Bezugszeichenliste

- 10: Wandler
- 11: Transformer von niederfrequenter in hochfrequente Energie
- 12: Filter/Kodierungseinrichtung
- 13/14: Funkenelektroden
- 15: Metallisierung
- 19: Drossel
- 20: Induktivität
- 22: Interdigitalwandler
- 23: Reflektionsstreifen
- 24: Antennen
- 41: Obere Elektrode
- 42: Untere Elektrode
- 101: Substrat
- 110: Piezoelektrisches Plättchen

## Patentansprüche

1. Anordnung zur Erzeugung kodierter Hochfrequenzsignale mit
- einem Wandler (10), der eine aus einem Prozeß oder aus der Umgebung der Anordnung verfügbare nicht-elektrische Primärenergie (P) in niederfrequente elektrische Energie umsetzt,
- einem Element (11) mit nichtlinearer Kennlinie zur Umwandlung der niederfrequenten elektrischen Energie in hochfrequente elektrische Energie in Form eines Hochfrequenzsignals
- einer Kodierungseinrichtung (23) zur Erzeugung eines kodierten Signals aus der hochfrequenten elektrischen Energie und
- einem zwischen dem Element (11) und der Kodierungseinrichtung (23) angeordneten Filter (12) zur Selektion eines Schmalbandsignals aus der hochfrequenten elektrischen Energie, oder mit einer Kodierungseinrichtung, die entsprechende zusätzliche Filtereigenschaften aufweist.

2. Anordnung nach Anspruch 1,
bei der die Kodierungseinrichtung (12,23) gegenüber zumindest einem Umgebungsparameter empfindlich ist und bei der dem kodierten Signal eine Information über die Art und/oder Größe dieses Umgebungsparameters aufgeprägt wird.

3. Anordnung nach einem der Ansprüche 1 oder 2,
bei der der Wandler (10) zur Wandlung mechanischer Primärenergie (P) in elektrische Energie ausgebildet ist.

4. Anordnung nach Anspruch 3,
bei der der Wandler (10) als Piezoelement, als Induktions-Einrichtung, insbesondere mit Magnet und elektrischer Spule, oder zur Erzeugung von elektrostatischer Ladung ausgebildet ist.

5. Anordnung nach einem der Ansprüche 1 oder 2,
bei der der Wandler (10) zur Wandlung thermischer Primärenergie (P) mit zeitlichem oder örtlichen Gradienten in elektrische Energie ausgebildet ist.

6. Anordnung nach Anspruch 5,
bei der der Wandler (10) als pyroelektrisches Element (101) oder als Thermoelementanordnung ausgebildet ist.

7. Anordnung nach einem der Ansprüche 1 - 3,
bei der der Wandler (10) als strahlungsempfindliches Bauelement für IR, sichtbares Licht oder UV ausgebildet ist.

8. Anordnung nach einem der Ansprüche 1 bis 7,
bei der als Element (11) mit nicht-linearer Kennlinie ein Entladungselement (13,14) vorgesehen ist.

9. Anordnung nach Anspruch 8,
bei der als Entladungselement (13,14) eine Funkenstrecke oder eine Gasentladungsröhre vorgesehen ist.

10. Anordnung nach einem der Ansprüche 1 bis 7,
bei der als Element (11) mit nichtlinearer Kennlinie ein Halbleiter-Bauelement vorgesehen ist, das bei einer Grenzspannung eine schnelle Widerstandsänderung zeigt.

11. Anordnung nach Anspruch 10,
bei der als Element (11) eine im Sperr-Durchbruch arbeitende Diode, eine Varaktor- Diode, ein Avalange- Halbleiterelement oder ein Thyristor vorgesehen ist.

12. Anordnung nach einem der Ansprüche 1 bis 7,
bei der als Element (11) mit nichtlinearer Kennlinie ein Relais vorgesehen ist.

13. Anordnung nach Anspruch 12,
bei der das Relais als Silizium Mikrorelais oder als Relais mit piezoelektrischer Zunge ausgebildet ist

14. Anordnung nach einem der Ansprüche 1 bis 13,
bei der als Filter (12) und/oder als Kodierungseinrichtung ein elektroakustischer Wandler (110) vorgesehen ist.

15. Anordnung nach Anspruch 14,
bei der der elektroakustische Wandler als OFW-Anordnung (110) oder als mit Scherwellen oder mit oberflächennahen Wellen arbeitende Anordnung ausgebildet ist.

16. Anordnung nach Anspruch 15,
bei der die OFW-Anordnung (110) als Resonatoranordnung, als Verzögerungsleitung, als dispersive Verzögerungsleitung oder als angezapfte Verzögerungsleitung ausgebildet ist.

17. Anordnung nach einem der Ansprüche 1 bis 16,
bei der die Kodierungseinrichtung (12) zur Durchführung einer Pulskompression zur störsicheren Übertragung des kodierten Signals ausgebildet ist.

18. Anordnung nach einem der Ansprüche 1 bis 14,
bei der als Filter (12) ein dielektrisches Filter, ein mechanisches Filter, ein Keramikfilter, ein Koaxial-Keramikfilter, ein Volumenschwinger oder ein LC-Filter vorgesehen ist.

19. Anordnung nach einem der Ansprüche 1 bis 18,
die mit einer Antenne (24) zum Aussenden des kodierten Signals und zur Ansteuerung/Triggerung einer Empfangseinrichtung gekoppelt ist.

20. Verfahren zur Erzeugung von kodierten Hochfrequenz-Funk-Signalen durch
- Umwandlung einer aus einem Prozeß oder aus der Umgebung der Anordnung verfügbaren nicht-elektrischen Primärenergie (P) in niederfrequente elektrische Energie mittels Reibung, piezoelektrischem, pyroelektrischem, thermoelektrischem, photoelektrischem, photovoltaischem oder elektrodynamischem Effekt,
- Umwandlung dieser niedrigfrequenten elektrischen Energie mittels eines Element (11) mit nichtlinearer Kennlinie in hochfrequente elektrische Energie
- gegebenenfalls Ausfiltern eines Schmalband-Hochfrequenzsignals aus einer breitbandigeren Hochfrequenzenergie und
- Aufprägen einer Kodierung auf das Schmalband-Hochfrequenzsignal

21. Verfahren nach Anspruch 20,
bei dem eine für zumindest einen Umgebungsparameter empfindliche Kodierungseinrichtung (23) verwendet wird, die die Kodierung des Schmalband-Hochfrequenzsignals in Abhängigkeit von der Art oder Größe des Umgebungsparameters erzeugt.

22. Verfahren nach Anspruch 20 oder 21,
bei dem als Umgebungparameter eine Kraft, ein Druck, eine Temperatur, eine Strahlung, ein Impedanzsprung, die Art oder Konzentration von Gasen, Flüssigkeiten, Dämpfen, chemischen oder biologischen Stoffen auf die Kodierungseinrichtung einwirkt, wobei ein von dem Umgebungparameter abhängige Kodierung des Schmalband-Hochfrequenzsignal erzeugt.

23. Verwendung der Vorrichtung nach einem der Ansprüche 1 bis 19 als Schalter für eine mit Funk ansprechbare und/oder schaltbare elektrische Vorrichtung.

24. Verwendung der Vorrichtung nach einem der Ansprüche 1 bis 19 zur Funk-Übertragung von für den Sender spezifischen kodierten Signalen an eine Überwachungseinrichtung.

25. Verwendung der vorrichtung nach einem der Ansprüche 1 bis 19 als ohne zusätzliche Stromversorgung aktiven Sensor für einen Umgebungparameter mit drahtloser Datenübermittlung.

## Claims

1. Arrangement for generating coded high-frequency signals, having
- a converter (10), which converts a non-electrical primary energy (P) available from a process or from the surroundings of the arrangement into low-frequency electrical energy,
- an element (11) with a nonlinear characteristic curve for converting the low-frequency electrical energy into high-frequency electrical energy, in the form of a broadband high-frequency signal,
- a coding device (23) for generating a coded signal from the high-frequency electrical energy, and
- a filter (12) for selecting a narrowband signal from the high-frequency electrical energy, said filter being arranged between the element (11) and the coding device (23), or having a coding device having corresponding additional filter properties.

2. Arrangement according to Claim 1,
in which the coding device (12, 23) is sensitive with respect to at least one ambient parameter, and in which an information item concerning the nature and/or size of this ambient parameter is impressed on the coded signal.

3. Arrangement according to one of Claims 1 or 2,
in which the converter (10) is designed to convert a mechanical primary energy (P) into electrical energy.

4. Arrangement according to Claim 3,
in which the converter (10) is designed as a piezoelectric element, as an induction device, in particular with a magnet and electrical coil, or for generating electrostatic charge.

5. Arrangement according to one of Claims 1 or 2,
in which the converter (10) is designed to convert thermal primary energy (P) with a temporal or local gradient into electrical energy.

6. Arrangement according to Claim 5,
in which the converter (10) is designed as a pyroelectric element (101) or as a thermoelement arrangement.

7. Arrangement according to one of Claims 1 - 3,
in which the converter (10) is designed as a radiation-sensitive component for IR, visible light or UV.

8. Arrangement according to one of Claims 1 to 7,
in which a discharge element (13, 14) is provided as the element (11) with a nonlinear characteristic curve.

9. Arrangement according to Claim 8,
in which a spark gap or a gas discharge tube is provided as the discharge element (13, 14).

10. Arrangement according to one of Claims 1 to 7,
in which a semiconductor component which exhibits a rapid change in resistance at a limiting voltage is provided as the element (11) with a nonlinear characteristic curve.

11. Arrangement according to Claim 10,
in which a diode operating at reverse breakdown, a varactor diode, an avalanche semiconductor element or a thyristor is provided as the element (11).

12. Arrangement according to one of Claims 1 to 7,
in which a relay is provided as the element (11) with a nonlinear characteristic curve.

13. Arrangement according to Claim 12,
in which the relay is designed as a silicon microrelay or as a relay with a piezoelectric reed

14. Arrangement according to one of Claims 1 to 13,
in which an electroacoustic transducer (110) is provided as the filter (12) and/or as the coding device.

15. Arrangement according to Claim 14,
in which the electroacoustic transducer is designed as an SW arrangement (110) or as an arrangement operating with shear waves or with waves near the surface,

16. Arrangement according to Claim 15,
in which the SW arrangement (110) is designed as a resonator arrangement, as a delay line, as a dispersive delay line or as a tapped delay line.

17. Arrangement according to one of Claims 1 to 16,
in which the coding device (12) is designed to carry out pulse compression for the purpose of transmitting the coded signal in a manner immune to interference.

18. Arrangement according to one of Claims 1 to 14,
in which a dielectric filter, a mechanical filter, a ceramic filter, a coaxial ceramic filter, a bulk oscillator or an LC filter is provided as the filter (12).

19. Arrangement according to one of Claims 1 to 18,
which is coupled to an antenna (24) for emitting the coded signal and for driving/triggering a receiving device.

20. Method for generating coded high-frequency radio signals by
- conversion of a non-electrical primary energy (P) available from a process or from the surroundings of the arrangement into low-frequency electrical energy by means of friction, piezoelectric, pyroelectric, thermoelectric, photoelectric, photovoltaic or electrodynamic effect,
- conversion of this low-frequency electrical energy into broadband high-frequency electrical energy by means of an element (11) with a nonlinear characteristic curve,
- if appropriate, filtering of a narrowband high-frequency signal out from a broader-band high-frequency energy, and
- impression of a coding on the narrowband high-frequency signal

21. Method according to Claim 20,
in which a coding device (23) which is sensitive to at least one ambient parameter is used, which coding device generates the coding of the narrowband high-frequency signal as a function of the nature or size of the ambient parameter.

22. Method according to Claim 20 or 21,
in which the ambient parameter that acts on the coding device is a force, a pressure, a temperature, a radiation, a sudden impedance change, the nature or concentration of gases, liquids, vapours, chemical or biological substances, a coding of the narrowband high-frequency signal that is dependent on the ambient parameter [lacuna] generated.

23. Use of the apparatus according to one of Claims 1 to 19 as a switch for an electrical apparatus that is switchable and/or responsive by radio.

24. Use of the apparatus according to one of Claims 1 to 19 for the radio transmission of coded signals specific to the transmitter to a monitoring device.

25. Use of the apparatus according to one of Claims 1 to 20 as an active sensor, without an additional power supply, for an ambient parameter with wirefree data communication.

## Revendications

1. Dispositif pour produire des signaux haute fréquence codés comportant
- un convertisseur (10) qui convertit une énergie (P) primaire non électrique disponible à partir d'un processus ou à partir de l'environnement du dispositif en énergie électrique basse fréquence,
- un élément (11) à courbe caractéristique non linéaire pour la conversion de l'énergie électrique basse fréquence en énergie électrique haute fréquence sous la forme d'un signal haute-fréquence
- un dispositif (23) de codage pour produire un signal codé à partir de l'énergie électrique haute fréquence et
- un filtre (12), disposé entre l'élément (11) et le dispositif (23) de codage, pour la sélection d'un signal à bande étroite à partir de l'énergie électrique haute fréquence, ou comportant un dispositif de codage qui comporte des propriétés de filtre supplémentaires correspondantes.

2. Dispositif suivant la revendication 1, dans lequel le dispositif (12, 23) de codage est sensible à au moins un paramètre de l'environnement et dans lequel il est imprimé dans le signal codé une information sur le genre et/ou la grandeur de ce paramètre de l'environnement.

3. Dispositif suivant l'une des revendications 1 ou 2, dans lequel le convertisseur (10) est réalisé pour la conversion d'énergie (P) primaire mécanique en énergie électrique.

4. Dispositif suivant la revendication 3,
dans lequel le convertisseur (10) est réalisé en élément piézoélectrique, en dispositif à induction, notamment comportant un aimant et une bobine électrique, ou pour la production de charge électrostatique.

5. Dispositif suivant l'une des revendications 1 ou 2,
dans lequel le convertisseur (10) est réalisé pour la conversion d'énergie (P) primaire thermique à gradients dans le temps ou localisés en énergie électrique.

6. Dispositif suivant la revendication 5,
dans lequel le convertisseur (10) est réalisé en élément (101) pyroélectrique ou en dispositif à thermocouple.

7. Dispositif suivant l'une des revendications 1 à 3,
dans lequel le convertisseur (10) est réalisé en composant sensible au rayonnement pour des infrarouges, de la lumière visible ou des ultraviolets.

8. Dispositif suivant l'une des revendications 1 à 7,
dans lequel il est prévu comme élément (11) à courbe caractéristique non linéaire un élément (13,14) de décharge.

9. Dispositif suivant la revendication 8,
dans lequel il est prévu comme élément (13,14) de décharge une distance de décharge ou un tube à décharge dans un gaz.

10. Dispositif suivant l'une des revendications 1 à 7, dans lequel il est prévu comme élément (11) à courbe caractéristique non linéaire un composant à semi-conducteur qui présente pour une tension limite une variation rapide de résistance.

11. Dispositif suivant la revendication 10, dans lequel il est prévu comme élément (11) une diode travaillant en blocage-claquage, une diode à varaktor, un élément semi-conducteur à avalange ou un thyristor.

12. Dispositif suivant l'une des revendications 1 à 7,
dans lequel il est prévu comme élément (11) à courbe caractéristique non linéaire un relais.

13. Dispositif suivant la revendication 12, dans lequel le relais est réalisé en microrelais en silicium ou en relais à lame piézoélectrique.

14. Dispositif suivant l'une des revendications 1 à 13, dans lequel il est prévu comme filtre (12) et/ou comme dispositif de codage un transducteur (110) électroacoustique.

15. Dispositif suivant la revendication 14, dans lequel le transducteur électroacoustique est réalisé en dispositif (110) à onde de surface ou en dispositif travaillant par ondes de cisaillement ou par ondes proches de la surface.

16. Dispositif suivant la revendication 15, dans lequel le dispositif (110) à onde de surface est réalisé en dispositif résonateur, en ligne de temporisation, en ligne de temporisation dispersive ou en ligne de temporisation rattachée.

17. Dispositif suivant l'une des revendications 1 à 16, dans lequel Ie dispositif (12) de codage est réalisé pour l'exécution d'une compression d'impulsion en vue de la transmission sans parasite du signal codé.

18. Dispositif suivant l'une des revendications 1 à 14, dans lequel il est prévu comme filtre (12) un filtre diélectrique, un filtre mécanique, un filtre céramique, un filtre céramique coaxial, un résonateur d'ondes acoustiques en volume ou un filtre LC.

19. Dispositif suivant l'une des revendications 1 à 18, qui est couplé à une antenne (24) pour émettre le signal codé et pour commander/déclencher un dispositif de réception.

20. Procédé de production de signaux radio-électriques haute fréquence codés par
- conversion d'une énergie (P) primaire non électrique, disponible à partir d'un procédé ou à partir de l'environnement du dispositif, en énergie électrique basse fréquence au moyen d'une friction, d'un effet piézoélectrique, pyroélectrique, thermoélectrique, photoélectrique, photovoltanique ou électrodynamique,
- conversion de cette énergie électrique basse fréquence au moyen d'un élément (11) à courbe caractéristique non linéaire en énergie électrique haute fréquence
- le cas échéant, filtrage d'un signal haute fréquence à bande étroite à partir d'une énergie haute fréquence à bande plus large et
- impression d'un codage sur le signal haute fréquence à bande étroite.

21. Procédé suivant la revendication 20,
dans lequel on utilise un dispositif (23) de codage qui est sensible à au moins un paramètre de l'environnement et qui produit le codage du signal haute fréquence à bande étroite en fonction du genre ou de la valeur du paramètre de l'environnement.

22. Procédé suivant la revendication 20 ou 21,
dans lequel il agit comme paramètre de l'environnement sur le dispositif de codage une force, une pression, une température, un rayonnement, un saut d'impédance, le genre où la concentration de gaz, de liquide, de vapeur, de substances chimiques ou biologiques, un codage dépendant du paramètre de l'environnement produisant le signal haute fréquence à bande étroite.

23. Utilisation du dispositif suivant l'une des revendications 1 à 19 comme commutateur pour un dispositif électrique pouvant être sollicité et/ou commuté par radio.

24. Utilisation du dispositif suivant l'une des revendications 1 à 19 pour la radiotransmission à dispositif de surveillance de signaux codés spécifiques à l'émetteur.

25. Utilisation du dispositif suivant rune des revendications 1 à 19 comme détecteur actif sans alimentation en courant supplémentaire pour un paramètre de l'environnement avec transmission de données sans fil.
